# FASCICULE DE BREVET EUROPEEN

(11) **EP 3 386 283 B1**
(45) Date de publication et mention de la délivrance du brevet: **09.06.2021**
(21) Numéro de dépôt: 18165906.1
(22) Date de dépôt: 05.04.2018
(51) Int. Cl.: H05K 5/00, G01D 11/24, G08B 13/08

(54) **APPAREIL ÉLECTRONIQUE ET PROCÉDÉ DE FABRICATION DUDIT APPAREIL ÉLECTRONIQUE**
ELEKTRONISCHES GERÄT UND HERSTELLUNGSVERFAHREN DIESES ELEKTRONISCHEN GERÄTS
ELECTRONIC APPARATUS AND METHOD FOR MANUFACTURING SAID ELECTRONIC APPARATUS

(30) Priorité: 06.04.2017 FR 1753010
(43) Date de publication de la demande: 10.10.2018
(73) Titulaire: HAGER SECURITY (Société par Actions Simplifiée), 38920 Crolles (FR)
(72) Inventeur: Ruffieux, Philippe, 38420 Domene (FR)
(74) Mandataire: Cabinet Nuss

(56) Documents cités:
- WO-A1-2011/101524
- WO-A1-2015/040144
- Honeywell: "Honeywell Model 5811 Installation Instructions", , 31 août 2011 (2011-08-31), pages 1-2, XP055430813, United States Extrait de l'Internet: URL:http://www.advancedsecuritysolution.co m/manuals/5811-Window-Door-Sensors.pdf [extrait le 2017-11-30]

## Description

La présente invention concerne le domaine des appareils électroniques et plus particulièrement un capteur pour dispositif d'alarme.

L'art antérieur connu comprend: Honeywell: "Honeywell Model 5811 Installation Instructions", , 31 août 2011 (2011-08-31), pages 1-2, XP055430813, United States Extrait de l'Internet: URL:http://www.advancedsecuritysolution.com/manuals/5811-Window-Door-Sensors.pdf [extrait le 2017-11-30].

WO 2011/101524 A1 (VAISALA OYJ [FI]; STORMBOM LARS [FI]) 25 août 2011 (2011-08-25)

On connait déjà de la publication WO 2015/040144 A1, un capteur d'un système d'alarme sans fil pour des entrées de bâtiment de type fenêtres et portes. Le capteur allongé permet de détecter un changement d'état et comporte au moins un commutateur de capteur configuré pour détecter un état donné et un changement d'état entre l'état donné et au moins un autre état. Le capteur comprend en outre un microprocesseur configuré pour détecter le changement d'état dudit ou desdits commutateurs de capteur, un système d'antenne, un émetteur sans fil configuré pour recevoir un signal du microprocesseur identifiant un changement de l'état du ou des commutateurs de capteur et pour émettre ledit signal au moyen du système d'antenne, et une source d'alimentation pour fournir une alimentation électrique au microprocesseur, au ou aux commutateurs de capteur, et à l'émetteur sans fil, ledit ou lesdits commutateurs de capteur. Le microprocesseur, le système d'antenne, l'émetteur sans fil et la source d'alimentation sont incorporés dans le boîtier du capteur allongé afin d'atteindre une hauteur maximale du capteur inférieure à 5 millimètres. Ce capteur est conçu pour être monté dans les vides et les cavités, lesquels sont formés entre une porte ou une fenêtre et le cadre correspondant, c'est-à-dire la taille physique du capteur ne nécessite pas une modification, par exemple, du cadre de fenêtre. En outre, ce capteur ne requiert pas d'outils pour le monter et/ou l'installer, fournissant ainsi un montage et une installation faciles dans un système d'alarme. Toutefois, le boîtier du capteur dans lequel sont logés ses différents constituants comprend plusieurs pièces assemblées par collage pour garantir l'étanchéité du capteur. Il en résulte qu'après assemblage la source d'alimentation est enfermée à l'intérieur du boîtier et ne peut plus en être retirée. Par conséquent, lorsque la source d'alimentation est déchargée, celle-ci ne peut être remplacée par une source d'alimentation chargée. Le capteur doit par conséquent être remplacé dans son intégralité, car le démontage par décollement des éléments du boîtier provoquerait la destruction du capteur étant donné également sa fragilité du fait de sa faible épaisseur, qui est inférieure à 5mm.

La présente invention a pour but de proposer une solution miniaturisée et solide, dont l'alimentation électrique est aisément accessible et interchangeable sans risque de destruction de l'appareil électronique et qui permette de pallier les principaux inconvénients de la solution connue précitée et de surmonter ses limitations majeures.

L'invention concerne un capteur pour un dispositif d'alarme selon la revendication 1, et un procédé de fabrication selon la revendication 24.

L'invention sera mieux comprise, grâce à la description ci-après, qui se rapporte à plusieurs modes de réalisation préférés, donnés à titre d'exemples non limitatifs, et expliqués avec référence aux dessins schématiques annexés, dans lesquels :
la figure 1 est une vue en perspective en éclaté d'un appareil électronique dans une première variante de réalisation selon l'invention,
la figure 2A est une vue en perspective de l'appareil électronique dans la première variante de réalisation selon l'invention dans laquelle la portion amovible du cadre obture l'orifice d'accès de l'alimentation électrique,
la figure 2B est une vue en perspective de l'appareil électronique dans la première variante de réalisation selon l'invention dans laquelle la portion amovible du cadre est retirée,
les figures 3A et 3B sont des vues en perspective en éclaté d'un appareil électronique dans une deuxième variante de réalisation selon l'invention,
les figures 4A et 4B sont des vues en perspective de l'appareil électronique dans la deuxième variante de réalisation selon l'invention,
la figure 5 est une vue en coupe schématique partielle de l'appareil électronique dans la première variante selon l'invention,
la figure 6 est une vue en coupe schématique partielle de l'appareil électronique dans la première variante montrant une couche d'aspect,
la figure 7 est une vue en coupe schématique partielle de l'appareil électronique dans la première variante selon l'invention montrant un cadre,
la figure 8 est une vue en coupe schématique partielle de l'appareil électronique dans la première variante selon l'invention montrant une alimentation électrique,
la figure 9 est une vue en coupe schématique partielle de l'appareil électronique dans la deuxième variante selon l'invention,
la figure 10 est une vue en coupe schématique partielle de l'appareil électronique dans la première variante selon l'invention,
la figure 11 est une vue en coupe schématique partielle de l'appareil électronique dans la deuxième variante selon l'invention montrant une entretoise,
la figure 12 est une vue en coupe schématique partielle de l'appareil électronique dans la première variante selon l'invention montrant le panneau solaire,
la figure 13 est une vue en coupe schématique partielle de l'appareil électronique dans la deuxième variante montrant le panneau solaire,
la figure 14 est une vue de côté d'une partie de l'appareil électronique selon l'invention montrant un organe de détection à l'arrachement et un support, et
les figures 15, 16 et 17 sont des vues en perspective illustrant l'intégration de l'organe de détection à l'arrachement à un appareil électronique selon l'invention.

L'appareil électronique, tel qu'un capteur pour dispositif d'alarme, comprend au moins :
- un socle 1,
- un couvercle 2,
- un ensemble de composants électroniques 3, 30 aptes et destinés à être alimentés par une alimentation électrique 4,
le socle 1 et le couvercle 2 formant au moins un logement 10, 10', 15, 15', 29, 29', 32 comportant les composants électroniques 3, 30 et/ou ladite alimentation électrique 4.

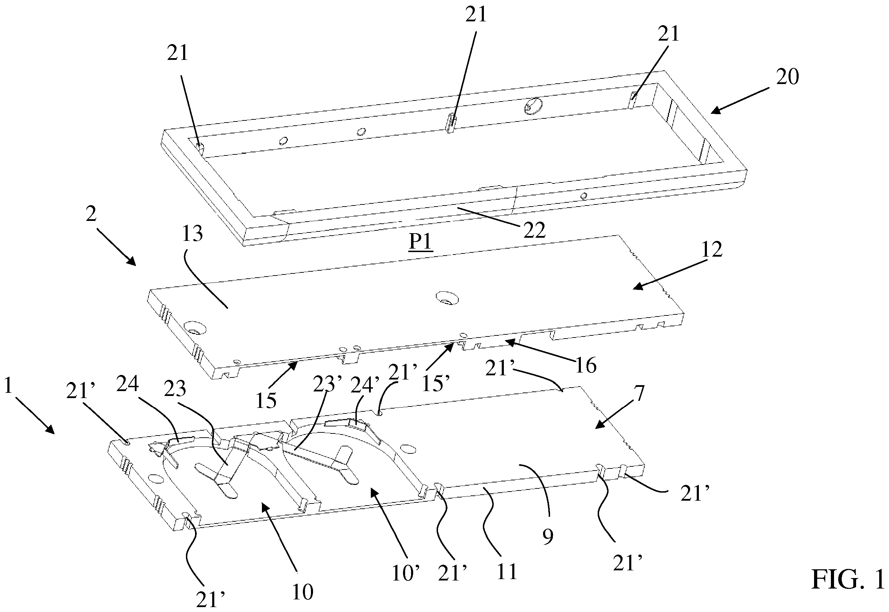

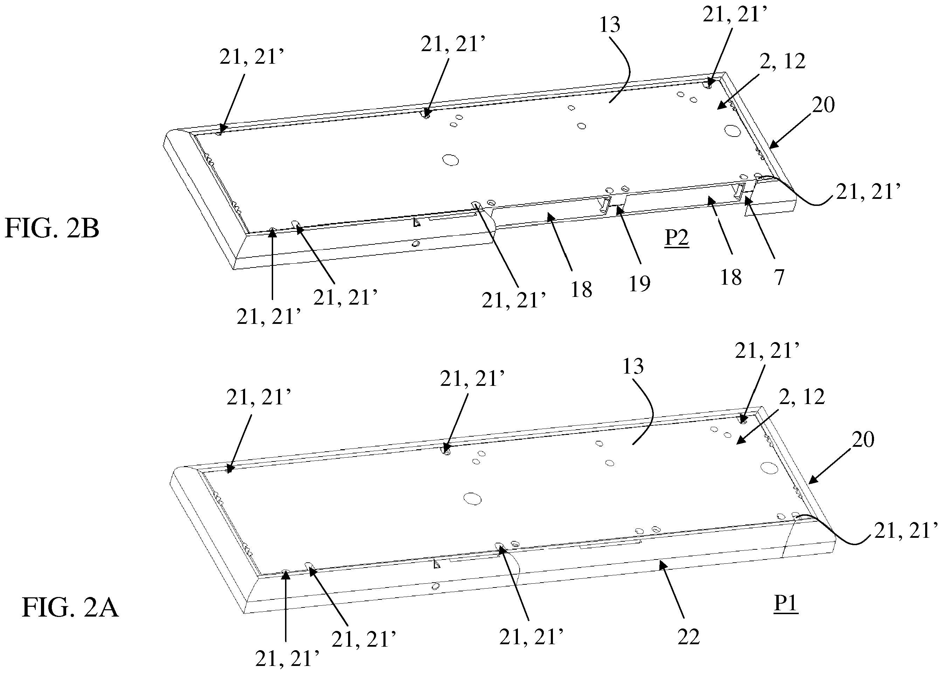

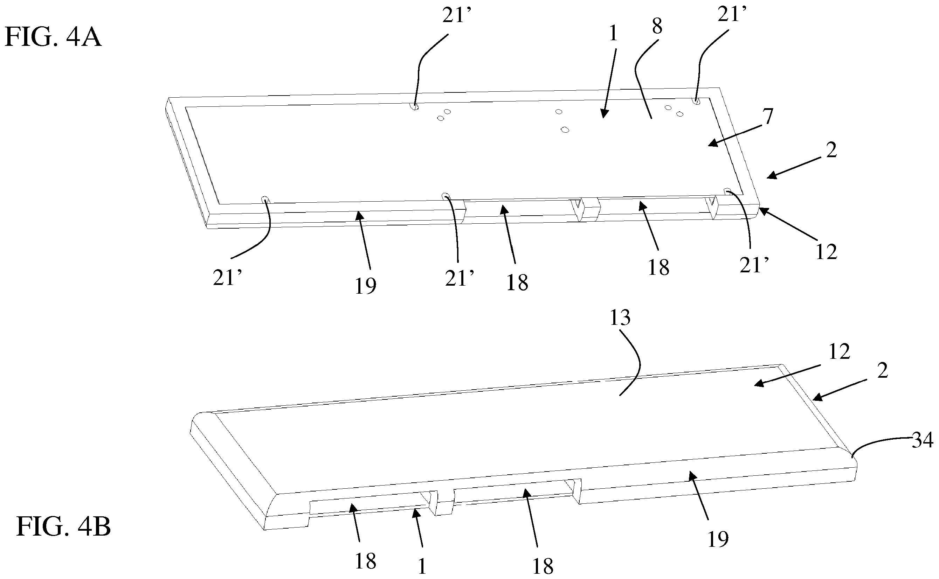

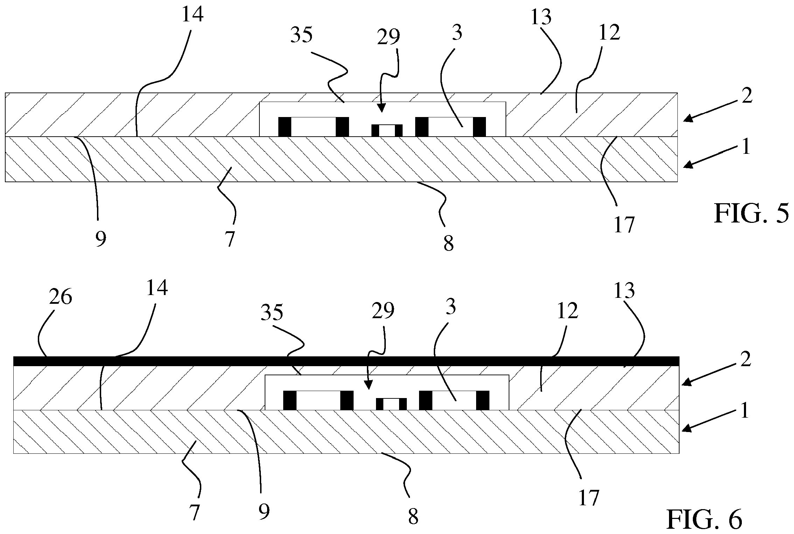

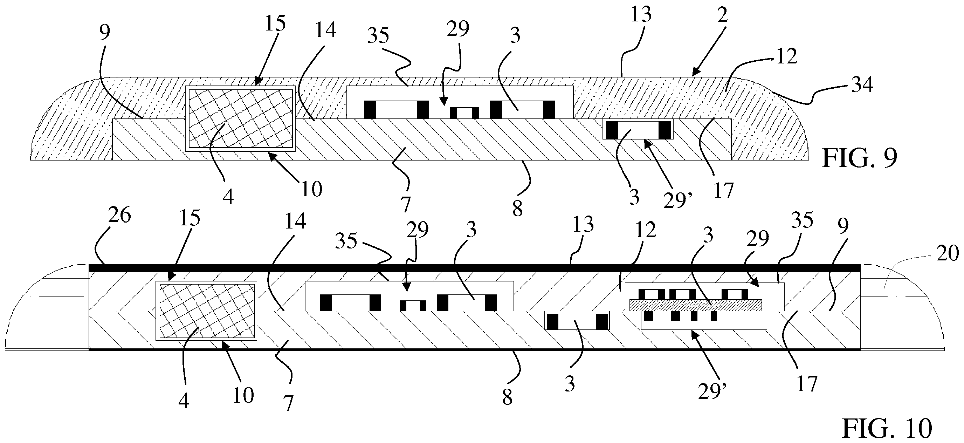

Conformément à l'invention, l'appareil électronique est caractérisé en ce que :
le socle 1 est constitué par un premier circuit imprimé dans lequel sont intégrés ledit ensemble de composants électroniques 3,
le premier circuit imprimé comprend une première paroi 7 en matériau isolant comprenant une première face externe 8 et une première face d'assemblage 9 opposée à la première face externe 8, la première face d'assemblage 9 comprenant au moins une première cavité 10, 10' apte et destinée à recevoir au moins en partie ladite alimentation électrique 4 et ouverte sur une première tranche 11 de la première paroi 7 (figures 1, 3A, 3B, 8, 9, 10, 11, 12 et 13),
les composants électroniques 3, 30 sont intégrés au moins en partie à la première paroi 7 (figures 5, 6, 7, 8, 9, 10, 11, 12, 13, 14, 16 et 17),
le couvercle 2 comprend une deuxième paroi 12 comprenant une deuxième face externe 13 et une deuxième face d'assemblage 14 opposée à la deuxième face externe 13, la deuxième face d'assemblage 14 comprenant au moins une deuxième cavité 15, 15' apte et destinée à recevoir au moins en partie ladite alimentation électrique 4 et ouverte sur une deuxième tranche 16 de la deuxième paroi 12 (figures 1, 3A, 3B, 8, 9, 10, 11, 12 et 13),
la première paroi 7 et la deuxième paroi 12 sont superposées et assemblées l'une à l'autre par assemblage de la première face d'assemblage 9 et de la deuxième face d'assemblage 14 par des moyens d'assemblage 17, 17' (figures 5 à 13),
la première cavité 10, 10' et la deuxième cavité 15, 15' sont disposées en regard l'une de l'autre pour former au moins un logement de réception de l'alimentation électrique 4 comprenant un orifice d'accès 18 prévus sur une tranche globale 19 de l'assemblage des premier et deuxième parois 7, 12 (figures 2B, 4A et 4B).

L'appareil électronique selon l'invention peut être un capteur, tel qu'un capteur pour dispositif d'alarme, une télécommande, un objet connecté, un dispositif de détection de chute, un détecteur de température et/ou d'humidité.

Avantageusement, cette configuration de l'appareil électronique permet un accès facilité à l'alimentation électrique 4, puisque l'alimentation électrique 4 peut être rendue accessible par la tranche globale 19 sans risquer d'endommager l'appareil électronique et sans avoir à décoller, ni démonter l'appareil électronique d'un support S auquel il est le cas échéant fixé. En effet, le socle 1 est constitué d'un premier circuit imprimé qui confère à l'appareil électronique une grande rigidité et une grande robustesse. En outre, le socle 1 a deux fonctions, d'une part, une fonction de circuit imprimé dans lequel un ensemble de composants électroniques 3, 30 est intégré et d'autre part, une fonction de socle pour reposer ou être fixé sur le support S. Avantageusement, lorsque l'appareil électronique est un capteur pour dispositif d'alarme, celui-ci peut aisément être camouflé dans son environnement domestique du fait de sa forme et de sa taille réduite.

Comme l'illustrent les figures 1 à 4B, la première face d'assemblage 9 de la première paroi 7 comprend deux premières cavités 10, 10' et la deuxième face d'assemblage 14 de la deuxième paroi 12 comprend deux deuxièmes cavités 15, 15' de sorte à forme deux logements de réception d'alimentation électrique 4 et deux orifices d'accès 18.

Le support S peut par exemple consister en un mur, un volet roulant ou non, une partie d'un ouvrant, tel qu'un cadre de fenêtre ou de porte, une fenêtre, une porte, en particulier lorsque l'appareil électronique est un capteur pour dispositif d'alarme.

Les moyens d'assemblage peuvent comprendre au moins un joint de soudure 17 (figures 5 à 13).

Un tel joint de soudure 17 permet créer une âme de renfort entre le socle 1 et le couvercle 2, permettant de renforcer davantage la rigidité et la robustesse de l'appareil électronique et de permettre de diminuer l'épaisseur du socle 1 et du couvercle 2. Il en résulte que l'appareil électronique peut avantageusement être miniaturisé sans que la rigidité et la robustesse de l'appareil électronique ne soient impactées. Par ailleurs, le socle 1 et le couvercle 2 peuvent également être reliés électroniquement entre eux.

La première paroi 7 du premier circuit imprimé peut comprendre des encoches 21' et qui sont répartis sur la tranche 11 pour recevoir le joint de soudure 17 (figures 1, 2A, 2B, 3A, 3B et 4A).

De manière alternative, le joint de soudure 17 peut être disposé à l'interface entre la première face d'assemblage 9 et la deuxième face d'assemblage 14.

L'assemblage du socle 1 et du couvercle 2 peut ainsi s'effectuer soit par la réalisation de joint de soudure 17 en utilisant des encoches 21', soit par dépôt de crème à braser sur la première face d'assemblage 9 et/ou la deuxième face d'assemblage 14 afin de créer un joint de soudure 17 entre la première face d'assemblage 9 et/ou la deuxième face d'assemblage 14. Dans ce cas l'assemblage est réalisé par un procédé de refusion, lors duquel l'appareil électronique est passé dans un four préférentiellement à 250 degrés Celsius.

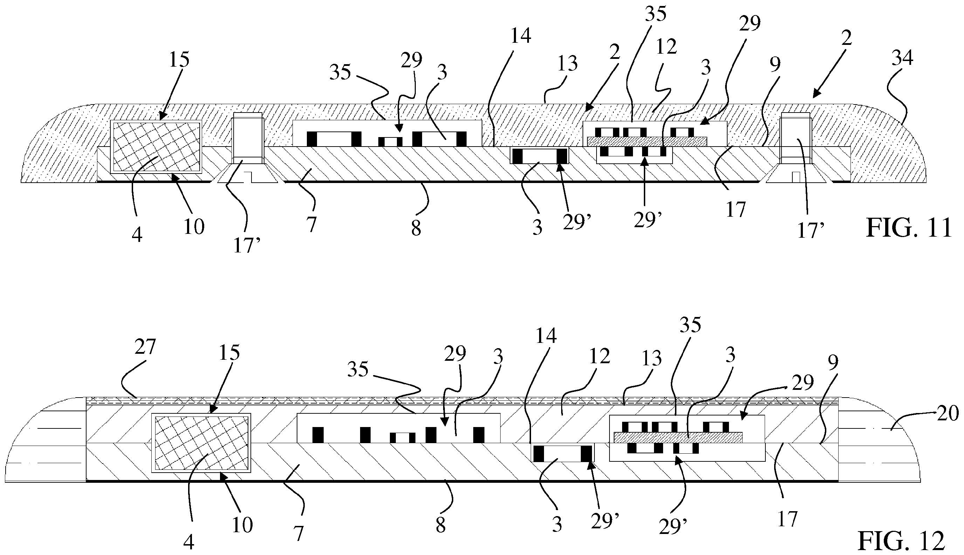

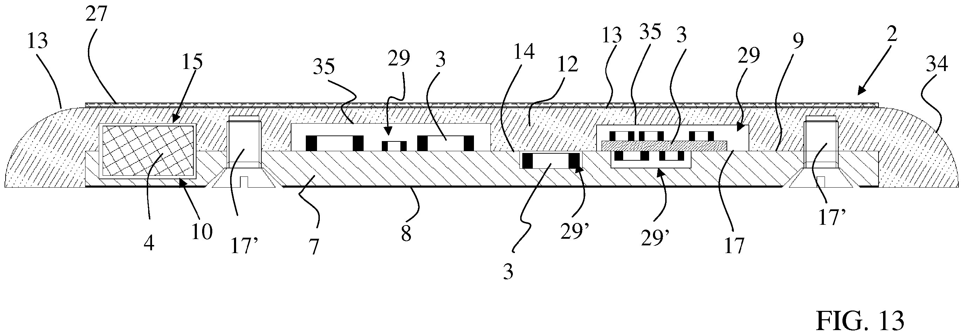

De manière optionnelle et additionnelle, les moyens d'assemblage peuvent comprendre au moins une vis 17' entretoise CMS (figures 11 et 13) ou au moins une vis classique.

Selon la première variante de réalisation, le couvercle 2 peut être constitué d'un deuxième circuit imprimé comprenant la deuxième paroi 12 et dont au moins une partie de la deuxième face d'assemblage 14 comprend au moins une couche conductrice (figures 1, 2A, 2B, 5, 6, 7, 8, 10 et 12).

Avantageusement, le couvercle 2 est constitué d'un deuxième circuit imprimé qui confère à l'appareil électronique une grande rigidité et une grande robustesse.

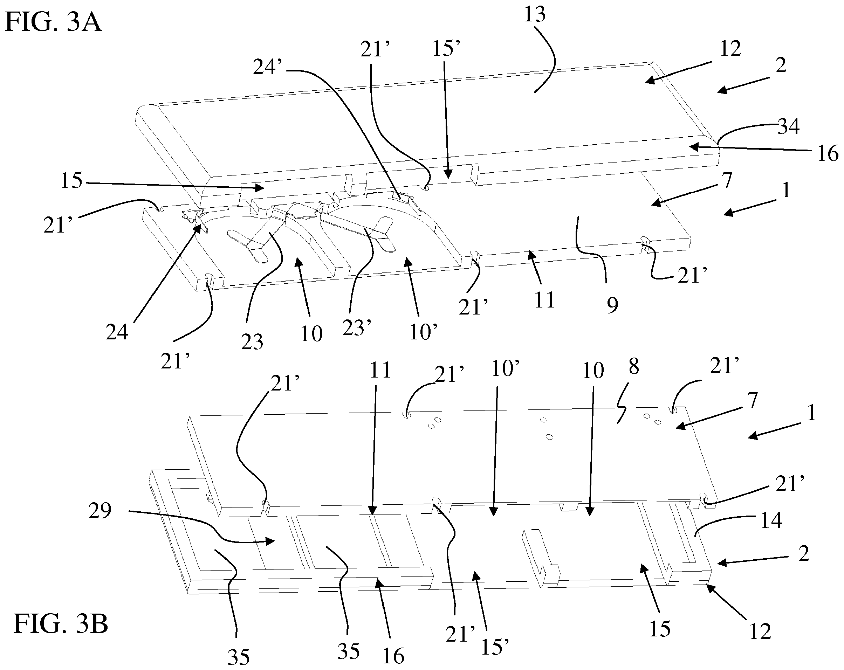

Selon la deuxième variante de réalisation, le couvercle 2 peut être constitué d'une pièce en matériau polymère moulée ou injectée constituant la deuxième paroi 12 et dont au moins une partie de la deuxième face d'assemblage 14 comprend au moins une couche conductrice 35 (figures 3A, 3B, 4A, 4B, 9, 11 et 13).

Avantageusement, ce choix de matériau permet d'obtenir un couvercle 2 dit plastronique et de diversifier la forme du couvercle 2 et d'ajouter au couvercle 2 d'autres fonctions mécaniques, telles que : un tiroir (non représenté), des bords arrondis 34 (figures 3A, 4B, 9, 11, 13), des appuis de boutons poussoirs (non représentés).

Selon la première variante de réalisation, l'appareil électronique peut comprendre un cadre 20 entourant la tranche globale 19 de l'assemblage des première et deuxième parois 7, 12, ledit cadre 20 étant fixé à la première paroi 7 et/ou à la deuxième paroi 12 par des moyens de fixation amovibles 21, 21' (figures 1, 2A, 2B, 7, 8, 10 et 12).

Les moyens de fixation peuvent comprendre une languette 21 complémentaire d'une encoche 21'. La languette 21 peut être disposée à l'intérieur du cadre 20 et l'encoche 21' peut être disposée sur la tranche 11 de la première paroi 7.

Le cadre 20 peut présenter une portion amovible 22 disposée en regard de l'orifice d'accès 18 pour obturer l'orifice d'accès 18 dans une position de fermeture P1 (figures 1 et 2A) et pour être retirée de l'orifice d'accès 18 pour donner accès à l'orifice d'accès 18 dans une position d'ouverture P2 (figure 2B).

Préférentiellement, la portion amovible 22 permet le cas échéant d'obturer deux orifices d'accès 18.

Conformément à la première variante de réalisation et à la deuxième variante de réalisation, la première cavité 10, 10' peut comprendre au moins un premier contact électrique 23, 23' et un deuxième contact électrique 24, 24' aptes et destinés à être reliés électriquement à l'alimentation électrique 4 (figures 1 et 3A).

Préférentiellement, le premier contact électrique 23, 23' et le deuxième contact électrique 24, 24'sont des composants montés en surface CMS.

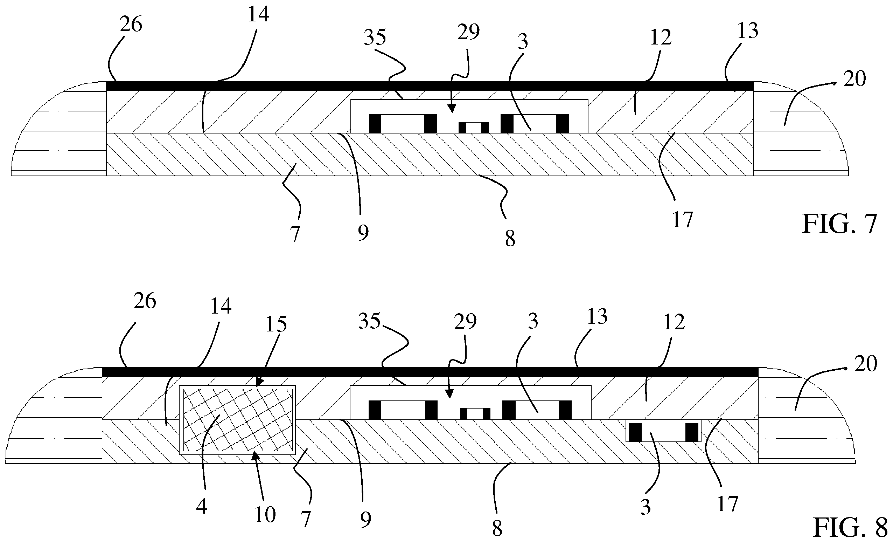

Conformément à la première variante de réalisation et à la deuxième variante de réalisation, les première et deuxième cavités 10, 10', 15, 15' peuvent comprendre une alimentation électrique 4 choisie seule ou en combinaison parmi : une pile électrique de type bouton, une batterie, une batterie rechargeable ou non rechargeable, une batterie lithium-ion rechargeable ou non rechargeable, une capacité (figures 8, 9, 10, 11, 12 et 13).

Par exemple, la pile bouton peut être une pile CR1616, de diamètre égal à 16 millimètres et d'épaisseur égale à 1,6 millimètres ou une pile CR2025, de diamètre égal à 20 millimètres et d'épaisseur égale à 2,5 millimètres.

L'appareil électronique peut comprendre un motif imprimé (non représenté) ou une couche d'aspect 26 (figures 6, 7, 8 et 10) respectivement imprimé ou collée sur la première face externe 8 et/ou la deuxième face externe 13.

Avantageusement, le motif imprimé ou la couche d'aspect 26 permettent d'imiter l'environnement de l'appareil électronique. Par exemple, le motif imprimé ou la couche d'aspect 26 peut consister en un effet bois et/ou peut être coloré. Avantageusement, lorsque l'appareil électronique est un capteur pour dispositif d'alarme, celui-ci peut aisément être camouflé dans son environnement domestique du fait de sa forme, de sa taille réduite et de son aspect.

L'appareil électronique peut comprendre au moins un panneau solaire 27 disposé sur la première face externe 8 et/ou la deuxième face externe 13 et relié électriquement au premier circuit imprimé du socle 1 (figures 12 et 13).

Avantageusement, un tel panneau solaire 27 permet de transformer l'énergie solaire en énergie électrique pouvant être stockée dans l'alimentation électrique 4. Le panneau solaire peut être un ensemble de cellules photovoltaïque, par exemple adhésif.

L'appareil électronique peut comprendre des moyens de fixation (non représentés) au support S sur la première face externe 8. Par exemple, les moyens de fixation peuvent consister en un adhésif double face, préférentiellement résistant aux chocs thermiques.

L'épaisseur de la tranche globale 19 de l'assemblage des première et deuxième parois 7, 12 peut être comprise entre 2,7 millimètres et 5 millimètres.

L'appareil électronique obtenu est ainsi avantageusement miniaturisé. En effet, l'épaisseur de l'appareil électronique se réduit quasiment à l'épaisseur de l'alimentation électrique 4. Par conséquent, l'appareil électronique peut aisément être fixé à un cadre d'ouvrant ou sur l'ouvrant sans nécessiter de le modifier.

L'épaisseur de la première paroi 7 au niveau de la première cavité 10, 10' et/ou de la deuxième paroi 12 au niveau de la deuxième cavité 15, 15' peut être comprise entre 0,4 millimètre et 0,8 millimètre, préférentiellement égale à 0,5 millimètre.

Le matériau isolant constituant la première paroi 7 peut être choisi parmi un polymère époxy, un polymère époxy haute densité, un composite d'un polymère époxy et de fibre de verre, préférentiellement FR-4.

De tels matériaux isolants sont particulièrement résistants.

Selon la première variante de réalisation, le matériau isolant constituant la deuxième paroi 12 peut être choisi parmi un polymère époxy, un polymère époxy haute densité, un composite d'un polymère époxy et de fibre de verre, préférentiellement FR-4.

### De tels matériaux isolants sont particulièrement résistants

Selon la deuxième variante de réalisation, le matériau isolant constituant la deuxième paroi 12 peut être un plastique dit haute température, tel qu'un polymère à cristaux liquides.

Le polymère à cristaux liquides présente l'avantage de permettre d'effectuer des assemblages du socle 1 et du couvercle 2 par un procédé de brasage en refusion, lors duquel l'appareil électronique passe dans un four jusqu'à une température de 250 degrés Celsius, mais est un matériau relativement couteux.

Selon la deuxième variante de réalisation, le matériau isolant constituant la deuxième paroi 12 peut être choisi parmi un polymère styrénique préférentiellement, l'acrylonitrile butadiène-styrène, un polymère polycarbonate.

Dans ce cas, l'assemblage du socle 1 et du couvercle 2 peut ainsi s'effectuer par la réalisation de joint de soudure 17 en utilisant les encoches 21', ce qui permet de limiter l'élévation de température de façon très localisée. En effet, dans ce cas le matériau du joint de soudure 17 est déposé ponctuellement au niveau des encoches 21' et s'écoule vers la deuxième paroi 12 en se figeant rapidement. Le matériau de la deuxième paroi 12 ne subit pas de température élevée.

Le matériau du joint de soudure 17 peut comprendre un alliage métallique comprenant de l'étain, du cuivre et de l'argent. La température de fusion du joint de soudure 17 est préférentiellement comprise entre 215 degrés Celsius et 260 degrés Celsius.

Le matériau constituant le cadre 20 peut être choisi parmi un matériau plastique ou un matériau élastomère. Par exemple, le matériau plastique du cadre 20 peut être du polycarbonate.

Selon la première variante de réalisation et la deuxième variante de réalisation, le premier circuit imprimé peut être un circuit imprimé tridimensionnel comprenant une pluralité de cavités 29' dans lesquelles sont intégrés au moins un des composants électroniques 3, 30.

Avantageusement, une telle configuration permet de protéger les composants de l'eau. En outre, un tel circuit imprimé tridimensionnel permet de contribuer à la miniaturisation du socle 1. De plus, les cavités 29' peuvent être reliées électriquement à différentes couches.

Selon la première variante de réalisation, le deuxième circuit imprimé peut être un circuit imprimé tridimensionnel comprenant une pluralité de cavités 29 recevant au moins en partie au moins un des composants électroniques 3.

Avantageusement, une telle configuration permet de protéger les composants électroniques 3 de l'eau. En outre, un tel circuit imprimé tridimensionnel permet de contribuer à la miniaturisation du couvercle 2.

De telles cavités 29, 29' de circuit imprimé tridimensionnel peuvent être usinées par fraisage avec une précision de plus ou moins 0,1 millimètre puis être traitées au laser par ablation afin de relier le fond des cavités à une couche interne du circuit imprimé.

En fonction des procédés d'assemblage utilisés, il est possible d'enterrer les composants électronique 3, 30 et de les relier électriquement à d'autres couches par des trous traversants ou des micro-vias.

Différentes formes de cavités 29 sont possibles, comme des cavités imbriqués de type double ou triple, des cavités avec chanfreins d'entrée, des chanfreins en périphérie du circuit imprimé.

Selon la deuxième variante de réalisation, la pièce en matériau polymère peut comprendre une pluralité de cavités 29 recevant au moins en partie au moins un des composants électroniques 3.

Selon la première variante de réalisation et la deuxième variante de réalisation, au moins une des cavités 29, 29' peut être recouverte en partie ou en totalité d'une couche conductrice 35 (figures 3B, 5 à 13).

Une telle couche conductrice 35 peut consister en une couche de cuivre et/ou de nickel et ou d'argent et/ou d'étain.

De telles cavités 29, 29' et de telles couches conductrices 35 peuvent être protégées par un vernis épargne.

Avantageusement, selon la deuxième variante de réalisation, le couvercle 2 obtenu est un couvercle dit plastronique. Un tel couvercle 2 dit plastronique présente sensiblement les mêmes fonctions qu'un circuit imprimé tridimensionnel. Ce couvercle 2 peut être fabriqué à partir d'une pièce injectée dans un matériau thermoplastique comprenant une substance active puis gravée par une méthode de gravure laser (LDS, laser direct structuring), lors de laquelle, un matériau thermoplastique comprenant une substance active est exposé et activé par une exposition à un faisceau laser. Cette substance active comprend des complexes de métaux qui sont activés par l'exposition au faisceau laser. Puis, une métallisation a lieu dans un bain de cuivre. La structure métallisée peut ensuite être recouvert de nickel et d'or. Compte tenu du fait que plusieurs fonctions mécaniques et électroniques sont rassemblées en une seule pièce dite plastronique, un tel couvercle 2 présente l'avantage d'être assez peu coûteux à produire comparativement à une solution traditionnelle ou plusieurs éléments sont additionnés, tels qu'un circuit imprimé, des composants électroniques, des connectiques, des pièces plastiques, des blindages etc.

Une telle couche conductrice 35 dans le couvercle 2 en matériau polymère peut former un contact électrique, un blindage ou une antenne, telle qu'une antenne bluetooth low energy, permettant par exemple la communication de l'appareil électronique avec un smartphone ou une tablette, une antenne pour le bi-protocole d'alarme 400-800 MHz, une antenne Wi-Fi ou encore une antenne pour puce RFID. Certaines antennes peuvent faire partie d'un module de communication, du type émetteur-récepteur de l'appareil électronique.

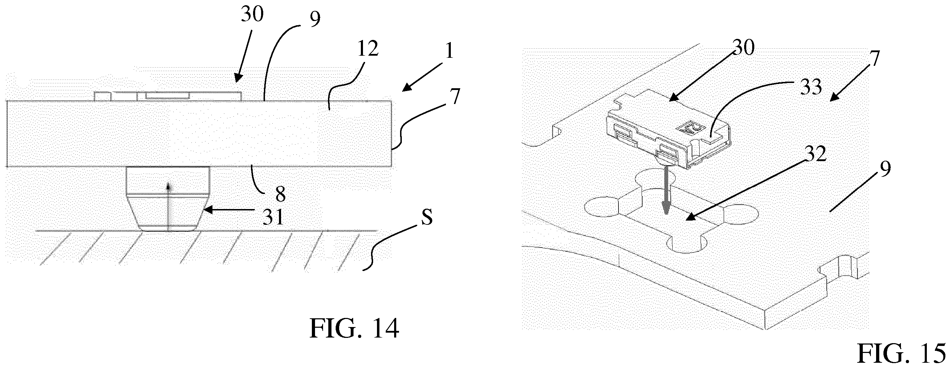

Un des composants électroniques du premier circuit imprimé peut consister en un organe de détection à l'arrachement 30 comprenant un élément d'actionnement 31 apte et destiné à venir en appui contre un support S lorsque l'appareil électronique est fixé à un support S et la première paroi 7 du premier circuit imprimé peut comprendre un logement 32 traversant recevant au moins en partie l'organe de détection à l'arrachement 30 et dont l'élément d'actionnement 31 fait saillie de la première face externe 8 et est fixé à la première face d'assemblage 9 par des moyens de fixation 33 (figures 14, 15, 16 et 17).

Avantageusement, cette configuration offre une solution d'autoprotection à l'arrachement ultra-mince, miniaturisée et intégrée. En effet, l'élément d'actionnement 31 est avantageusement accessible de la première face externe 8. Par ailleurs, l'ajout d'une telle fonction de protection à l'arrachement permet une homologation de l'appareil électronique selon l'invention auprès des organismes d'assurances en étant conforme à la norme NFA2P.

L'organe de détection à l'arrachement 30 peut être un interrupteur monostable normalement ouvert.

Dans ce cas, la consommation inutile d'énergie électrique est évitée puisque, lorsque l'élément d'actionnement 31 est actionné par le support S, aucun courant électrique ne circule. Ainsi, cette fonction additionnelle consomme très peu d'énergie. Après installation de l'appareil électronique sur le support S l'interrupteur est ouvert et en cas d'arrachement de l'appareil électronique du support S, un module de communication peut être activé pour transmettre une information à une centrale d'alarme ou une alarme sonore peut être directement activée. En effet, après installation, l'élément d'actionnement 31 est poussé par le support S. Il est en outre possible de prévoir un élément de protection (non représenté), tel qu'une pièce plastique (non représentée), disposée entre le support S et l'élément d'actionnement 31 pour protéger l'organe de détection à l'arrachement 30.

En particulier, l'organe de détection à l'arrachement 30 peut être un composant monté en surface, CMS. L'organe de détection à l'arrachement 30 peut être résistant au dioxyde de soufre et être étanche.

Préférentiellement, l'organe de détection à l'arrachement 30 peut être soudé du côté de la première face d'assemblage 9

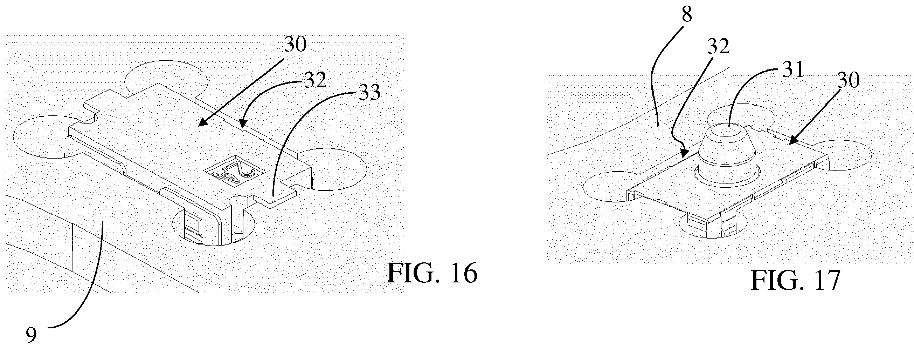

Les moyens de fixation 33 peuvent consister en des flasques ce qui permet de renforcer l'assemblage (figures 15 et 16).

L'appareil électronique peut être un capteur pour dispositif d'alarme et les composants électroniques 3 peuvent comprendre un accéléromètre et/ou un magnétomètre et/ou un composant magnéto résistif et/ou un indicateur sonore et/ou un indicateur visuelle et/ou des moyens d'émission et de réception d'ondes électromagnétiques et/ou un microcontrôleur.

Avantageusement, l'accéléromètre est sensible aux accélérations, tandis que le magnétomètre est sensible au mouvement, comme c'est le cas d'une boussole. En particulier, l'accéléromètre permet la détection des vibrations pour détecter une tentative d'effraction avant que celle-ci n'ait lieu et ainsi de former une pré-alarme. Le magnétomètre et/ou le composant magnéto résistif permet la détection de mouvement et donc de déterminer si la position du volet ou de l'ouvrant a changé et si une effraction est en cours. Le composant magnéto résistif fonctionne avec un aimant qui devient optionnel dans le cas de l'utilisation d'un composant magnétomètre. L'aimant permet dans ce cas d'augmenter la précision, par exemple, pour la détection d'une porte qui serait très légèrement entrouverte.

L'accéléromètre et/ou le magnétomètre et/ou le composant magnéto résistif peuvent présenter une sensibilité combinée réglable.

Avantageusement, il est ainsi possible de favoriser l'accéléromètre par rapport au magnétomètre et/ou au composant magnéto résistif.

Par exemple, l'accéléromètre peut ne pas être favorisé alors que le magnétomètre et/ou le composant magnéto résistif l'est, lorsque l'appareil électronique est installé sur un volet roulant qui est particulièrement sensible au vent et donc aux vibrations. Les fausses détections sont ainsi évitées.

Cette sensibilité peut être commandée et réglée à distance par l'intermédiaire des moyens d'émission et de réception d'ondes électromagnétiques, tel qu'un module de communication, par exemple, radiofréquences, en lien de communication avec une interface homme-machine, par exemple, une tablette ou un smartphone.

Un signal d'alarme, sonore, visuel peut être émis lorsque l'accéléromètre et/ou le magnétomètre et/ou le composant magnéto résistif sont activés et reliés à un avertisseur sonore ou à une centrale d'alarme pour signaler une effraction.

Conformément à l'invention, le procédé de fabrication d'un appareil électronique est caractérisé en ce que l'appareil électronique est tel que décrit précédemment et en ce que le procédé de fabrication comprend au moins :
- une étape d'assemblage, lors de laquelle, la première paroi 7 et la deuxième paroi 12 sont superposées et assemblées l'une à l'autre par assemblage de la première face d'assemblage 9 et de la deuxième face d'assemblage 14,
- une étape de soudage, lors de laquelle la première face d'assemblage 9 et la deuxième face d'assemblage 14 sont soudées entre elles.

Avantageusement, cette façon de procéder permet de créer au moins un joint de soudure 17 qui permet de créer une âme de renfort entre le socle 1 et le couvercle 2, permettant de renforcer davantage la rigidité et la robustesse de l'appareil électronique et de permettre de diminuer l'épaisseur du socle 1 et du couvercle 2. Il en résulte que l'appareil électronique peut avantageusement être miniaturisé sans que la rigidité et la robustesse de l'appareil électronique ne soient impactées. Par ailleurs, le socle 1 et le couvercle 2 peuvent également être reliés électroniquement entre eux.

L'étape de soudage peut être réalisée par soudage manuel ou robotisé au fer à souder ou par soudage à la vague ou par brasage sélectif ou par soudage au laser.

Lors d'une étape de sérigraphie préalable à l'étape d'assemblage et à l'étape de soudage, de la crème à braser peut être déposée au travers d'un pochoir sur la première face d'assemblage 9 et/ou la deuxième face d'assemblage 14 et l'étape de soudage peut être réalisée en refusion dans un four.

Lors d'une étape de fabrication du couvercle 2, préalable aux étapes d'assemblage et de soudage, le couvercle 2 peut être injecté dans un matériau thermoplastique comprenant une substance active pour former la deuxième paroi 12. Puis lors d'une étape de gravure, la deuxième paroi 12 peut être gravée par une méthode de gravure laser (LDS, laser direct structuring), lors de laquelle, le matériau thermoplastique comprenant la substance active peut être exposé et activé par une exposition à un faisceau laser. Cette substance active peut comprendre des complexes de métaux qui sont activés par l'exposition au faisceau laser. Puis, lors d'une étape de métallisation, la deuxième paroi 12 peut être plongée dans un bain de métal pour former au moins une couche conductrice.

Avantageusement, un couvercle 2, dit plastronique, est ainsi obtenu.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Capteur pour dispositif d'alarme, comprenant au moins :
- un socle (1),
- un couvercle (2),
- un ensemble de composants électroniques (3, 30) aptes et destinés à être alimentés par une alimentation électrique (4),
le socle (1) et le couvercle (2) formant au moins un logement (10, 10', 15, 15', 29, 29', 32) comportant les composants électroniques (3, 30) et/ou ladite alimentation électrique (4),
les composants électroniques (3) comprennent un accéléromètre et/ou un magnétomètre et/ou un composant magnéto résistif, capteur pour dispositif d'alarme **caractérisé en ce que** :
le socle (1) est constitué par un premier circuit imprimé dans lequel est intégré ledit ensemble de composants électroniques (3, 30),
le premier circuit imprimé comprend une première paroi (7) en matériau isolant comprenant une première face externe (8) et une première face d'assemblage (9) opposée à la première face externe (8), la première face d'assemblage (9) comprenant au moins une première cavité (10, 10') apte et destinée à recevoir au moins en partie ladite alimentation électrique (4) et ouverte sur une première tranche (11) de la première paroi (7),
les composants électroniques (3, 30) sont intégrés au moins en partie à la première paroi (7), le couvercle (2) comprend une deuxième paroi (12) comprenant une deuxième face externe (13) et une deuxième face d'assemblage (14) opposée à la deuxième face externe (13), la deuxième face d'assemblage (14) comprenant au moins une deuxième cavité (15, 15') apte et destinée à recevoir au moins en partie ladite alimentation électrique (4) et ouverte sur une deuxième tranche (16) de la deuxième paroi (12),
la première paroi (7) et la deuxième paroi (12) sont superposées et assemblées l'une à l'autre par assemblage de la première face d'assemblage (9) et de la deuxième face d'assemblage (14) par des moyens d'assemblage (17, 17'),
la première cavité (10, 10') et la deuxième cavité (15, 15') sont disposées en regard l'une de l'autre pour former au moins un logement de réception de l'alimentation électrique (4) comprenant un orifice d'accès (18) prévu sur une tranche globale (19) de l'assemblage des première et deuxième parois (7, 12).

2. Capteur pour dispositif d'alarme selon la revendication 1, **caractérisé en ce que** les moyens d'assemblage comprennent au moins un joint de soudure (17).

3. Capteur pour dispositif d'alarme selon l'une quelconque des revendications 1 à 2, **caractérisé en ce que** le couvercle (2) est constitué d'un deuxième circuit imprimé comprenant la deuxième paroi (12) et dont au moins une partie de la deuxième face d'assemblage (14) comprend au moins une couche conductrice.

4. Capteur pour dispositif d'alarme selon l'une quelconque des revendications 1 à 2, **caractérisé en ce que** le couvercle (2) est constitué d'une pièce en matériau polymère moulée ou injectée constituant la deuxième paroi (12) et dont au moins une partie de la deuxième face d'assemblage (14) comprend au moins une couche conductrice (35).

5. Capteur pour dispositif d'alarme selon l'une quelconque des revendications 1 à 4, **caractérisé en ce que** le capteur pour dispositif d'alarme comprend un cadre (20) entourant la tranche globale (19) de l'assemblage des première et deuxième parois (7, 12), ledit cadre (20) étant fixé à la première paroi (7) et/ou à la deuxième paroi (12) par des moyens de fixation amovibles (21, 21').

6. Capteur pour dispositif d'alarme selon la revendication 5, **caractérisé en ce que** le cadre (20) présente une portion amovible (22) disposée en regard de l'orifice d'accès (18) pour obturer l'orifice d'accès (18) dans une position de fermeture (P1) et pour être retirée de l'orifice d'accès (18) pour donner accès à l'orifice d'accès (18) dans une position d'ouverture (P2).

7. Capteur pour dispositif d'alarme selon l'une quelconque des revendications 1 à 6, **caractérisé en ce que** la première cavité (10, 10') comprend au moins un premier contact électrique (23, 23') et un deuxième contact électrique (24, 24') aptes et destinés à être reliés électriquement à l'alimentation électrique (4).

8. Capteur pour dispositif d'alarme selon l'une quelconque des revendications 1 à 7, **caractérisé en ce que** les première et deuxième cavités (10, 10', 15, 15') comprennent une alimentation électrique (4) choisie seule ou en combinaison parmi : une pile électrique de type bouton, une batterie, une batterie rechargeable ou non rechargeable, une batterie lithium-ion rechargeable ou non rechargeable, une capacité.

9. Capteur pour dispositif d'alarme selon l'une quelconque des revendications 1 à 8, **caractérisé en ce que** le capteur pour dispositif d'alarme comprend un motif imprimé ou une couche d'aspect (26) respectivement imprimé ou collée sur la première face externe (8) et/ou la deuxième face externe (13).

10. Capteur pour dispositif d'alarme selon l'une quelconque des revendications 1 à 9, **caractérisé en ce que** le capteur pour dispositif d'alarme comprend au moins un panneau solaire (27) disposé sur la première face externe (8) et/ou la deuxième face externe (13) et relié électriquement au premier circuit imprimé du socle (1).

11. Capteur pour dispositif d'alarme selon l'une quelconque des revendications 1 à 10, **caractérisé en ce que** l'épaisseur de la tranche globale (19) de l'assemblage des première et deuxième parois (7, 12) est comprise entre 2,7 millimètres et 5 millimètres.

12. Capteur pour dispositif d'alarme selon l'une quelconque des revendications 1 à 11, **caractérisé en ce que** l'épaisseur de la première paroi (7) au niveau de la première cavité (10, 10') et/ou de la deuxième paroi (12) au niveau de la deuxième cavité (15, 15') est comprise entre 0,4 millimètre et 0,8 millimètre, préférentiellement égale à 0,5 millimètre.

13. Capteur pour dispositif d'alarme selon l'une quelconque des revendications 1 à 12, **caractérisé en ce que** le matériau isolant constituant la première paroi (7) est choisi parmi un polymère époxy, un polymère époxy haute densité, un composite d'un polymère époxy et de fibre de verre, préférentiellement FR-4.

14. Capteur pour dispositif d'alarme selon l'une quelconque des revendications 1 à 13, **caractérisé en ce que** le matériau isolant constituant la deuxième paroi (12) est choisi parmi un polymère époxy, un polymère époxy haute densité, un composite d'un polymère époxy et de fibre de verre, préférentiellement FR-4, un polymère styrénique préférentiellement, l'acrylonitrile butadiène-styrène, un polymère polycarbonate, un polymère à cristaux liquides.

15. Capteur pour dispositif d'alarme selon l'une quelconque des revendications 2 à 14, **caractérisé en ce que** le matériau du joint de soudure (17) comprend un alliage métallique comprenant de l'étain, du cuivre et de l'argent.

16. Capteur pour dispositif d'alarme selon l'une quelconque des revendications 5 à 15, **caractérisé en ce que** le matériau constituant le cadre (20) est choisi parmi un matériau plastique ou un matériau élastomère.

17. Capteur pour dispositif d'alarme selon l'une quelconque des revendications 1 à 16, **caractérisé en ce que** le premier circuit imprimé est un circuit imprimé tridimensionnel comprenant une pluralité de cavités (29') dans lesquelles sont intégrés au moins un des composants électroniques (3, 30).

18. Capteur pour dispositif d'alarme selon l'une quelconque des revendications 1 à 3 et 5 à 17, **caractérisé en ce que** le deuxième circuit imprimé est un circuit imprimé tridimensionnel comprenant une pluralité de cavités (29) recevant au moins en partie au moins un des composants électroniques (3).

19. Capteur pour dispositif d'alarme selon l'une quelconque des revendications 1, 2, 4 à 17, **caractérisé en ce que** la pièce en matériau polymère comprend une pluralité de cavités (29) recevant au moins en partie au moins un des composants électroniques (3).

20. Capteur pour dispositif d'alarme selon l'une quelconque des revendications 17 à 19, **caractérisé en ce qu'**au moins une des cavités (29, 29') est recouverte en partie ou en totalité d'une couche conductrice (35).

21. Capteur pour dispositif d'alarme selon l'une quelconque des revendications 1 à 20, **caractérisé en ce qu'**un des composants électroniques du premier circuit imprimé consiste en un organe de détection à l'arrachement (30) comprenant un élément d'actionnement (31) apte et destiné à venir en appui contre un support (S) lorsque le capteur pour dispositif d'alarme est fixé à un support (S) et **en ce que** la première paroi (7) du premier circuit imprimé comprend logement (32) traversant recevant au moins en partie l'organe de détection à l'arrachement (30) et dont l'élément d'actionnement (31) fait saillie de la première face externe (8) et est fixé à la première face d'assemblage (9) par des moyens de fixation (33).

22. Capteur pour dispositif d'alarme selon la revendication 21, **caractérisé en ce que** l'organe de détection à l'arrachement (30) est un interrupteur monostable normalement ouvert.

23. Capteur pour dispositif d'alarme selon l'une quelconque des revendications 1 à 22, **caractérisé en ce que** les composants électroniques (3) comprennent un indicateur sonore et/ou un indicateur visuelle et/ou des moyens d'émission et de réception d'ondes électromagnétiques et/ou un microcontrôleur.

24. Procédé de fabrication d'un capteur pour dispositif d'alarme, **caractérisé en ce que** le capteur pour dispositif d'alarme est selon l'une quelconque des revendications 1 à 23, et **en ce que** le procédé de fabrication comprend au moins :
- une étape d'assemblage, lors de laquelle, la première paroi (7) et la deuxième paroi (12) sont superposées et assemblées l'une à l'autre par assemblage de la première face d'assemblage (9) et de la deuxième face d'assemblage (14),
- une étape de soudage, lors de laquelle la première face d'assemblage (9) et la deuxième face d'assemblage (14) sont soudées entre elles.

25. Procédé selon la revendication 24, **caractérisé en ce que** l'étape de soudage est réalisée par soudage manuel ou robotisé au fer à souder ou par soudage à la vague ou par brasage sélectif ou par soudage au laser.

26. Procédé selon la revendication 24, **caractérisé en ce que** lors d'une étape de sérigraphie préalable à l'étape d'assemblage et à l'étape de soudage, de la crème à braser est déposée au travers d'un pochoir sur la première face d'assemblage (9) et/ou la deuxième face d'assemblage (14) et **en ce que** l'étape de soudage est réalisée en refusion dans un four.

## Patentansprüche

1. Sensor für eine Alarmvorrichtung, der mindestens enthält:
- einen Sockel (1),
- einen Deckel (2),
- eine Einheit elektronischer Bauteile (3, 30), die fähig und dazu bestimmt sind, von einer Stromversorgung (4) versorgt zu werden,
wobei der Sockel (1) und der Deckel (2) mindestens eine Aufnahme (10, 10', 15, 15', 29, 29', 32) bilden, die die elektronischen Bauteile (3, 30) und/oder die Stromversorgung (4) enthält,
wobei die elektronischen Bauteile (3) einen Beschleunigungsmesser und/oder ein Magnetometer und/oder ein Magnetwiderstandsbauteil enthalten,
Sensor für eine Alarmvorrichtung, **dadurch gekennzeichnet, dass**:
der Sockel (1) aus einer ersten Leiterplatte besteht, in die die Einheit elektronischer Bauteilen (3, 30) integriert ist,
die erste Leiterplatte eine erste Wand (7) aus Isoliermaterial enthält, die eine erste Außenseite (8) und eine erste Zusammenbauseite (9) entgegengesetzt zur ersten Außenseite (8) enthält, wobei die erste Zusammenbauseite (9) mindestens einen ersten Hohlraum (10, 10') enthält, der fähig und dazu bestimmt ist, die Stromversorgung (4) zumindest zum Teil aufzunehmen, und auf einer ersten Schmalseite (11) der ersten Wand (7) offen ist,
die elektronischen Bauteile (3, 30) zumindest zum Teil in die erste Wand (7) integriert sind, der Deckel (2) eine zweite Wand (12) enthält, die eine zweite Außenseite (13) und eine zweite Zusammenbauseite (14) entgegengesetzt zur zweiten Außenseite (13) enthält,
wobei die zweite Zusammenbauseite (14) mindestens einen zweiten Hohlraum (15, 15') enthält, der fähig und geeignet ist, die Stromversorgung (4) zumindest zum Teil aufzunehmen, und auf einer zweiten Schmalseite (16) der zweiten Wand (12) offen ist,
die erste Wand (7) und die zweite Wand (12) übereinander liegen und durch Zusammenbau der ersten Zusammenbauseite (9) und der zweiten Zusammenbauseite (14) durch Zusammenbaueinrichtungen (17, 17') zusammengebaut sind,
der erste Hohlraum (10, 10') und der zweite Hohlraum (15, 15') einander gegenüber angeordnet sind, um mindestens einen Aufnahmesitz der Stromversorgung (4) zu bilden, der eine Zugangsöffnung (18) enthält, die auf einer gesamten Schmalseite (19) des Zusammenbaus der ersten und zweiten Wände (7, 12) vorgesehen ist.

2. Sensor für eine Alarmvorrichtung nach Anspruch 1, **dadurch gekennzeichnet, dass** die Zusammenbaueinrichtungen mindestens eine Schweißnaht (17) enthalten.

3. Sensor für eine Alarmvorrichtung nach einem der Ansprüche 1 bis 2, **dadurch gekennzeichnet, dass** der Deckel (2) aus einer zweiten Leiterplatte besteht, die die zweite Wand (12) enthält und von der mindestens ein Teil der zweiten Zusammenbauseite (14) mindestens eine leitende Schicht enthält.

4. Sensor für eine Alarmvorrichtung nach einem der Ansprüche 1 bis 2, **dadurch gekennzeichnet, dass** der Deckel (2) aus einem Werkstück aus einem geformten oder gespritzten Polymermaterial besteht, das die zweite Wand (12) bildet und von dem mindestens ein Teil der zweiten Zusammenbauseite (14) mindestens eine leitende Schicht (35) enthält.

5. Sensor für eine Alarmvorrichtung nach einem der Ansprüche 1 bis 4, **dadurch gekennzeichnet, dass** der Sensor für eine Alarmvorrichtung einen Rahmen (20) enthält, der die gesamte Schmalseite (19) des Zusammenbaus der ersten und zweiten Wände (7, 12) umgibt, wobei der Rahmen (20) durch entfernbare Befestigungseinrichtungen (21, 21) an der ersten Wand (7) und/oder an der zweiten Wand (12) befestigt ist.

6. Sensor für eine Alarmvorrichtung nach Anspruch 5, **dadurch gekennzeichnet, dass** der Rahmen (20) einen entfernbaren Abschnitt (22) enthält, der gegenüber der Zugangsöffnung (18) angeordnet ist, um die Zugangsöffnung (18) in einer Schließstellung (P1) zu verschließen und um von der Zugangsöffnung (18) entfernt zu werden, um den Zugang zur Zugangsöffnung (18) in einer Öffnungsstellung (P2) zu gewähren.

7. Sensor für eine Alarmvorrichtung nach einem der Ansprüche 1 bis 6, **dadurch gekennzeichnet, dass** der erste Hohlraum (10, 10') 30 mindestens einen ersten elektrischen Kontakt (23, 23') und einen zweiten elektrischen Kontakt (24, 24') enthält, die fähig und dazu bestimmt sind, elektrisch mit der Stromversorgung (4) verbunden zu werden.

8. Sensor für eine Alarmvorrichtung nach einem der Ansprüche 1 bis 7, **dadurch gekennzeichnet, dass** der erste und der zweite Hohlraum (10, 10', 15, 15') eine Stromversorgung (4) enthalten, die alleine oder in Kombination ausgewählt wird unter: einer elektrischen Zelle der Art Knopfzelle, einer Batterie, einer wiederaufladbaren oder nicht wiederaufladbaren Batterie, einer wiederaufladbaren oder nicht wiederaufladbaren Lithium-Ionen-Batterie, einem Kondensator.

9. Sensor für eine Alarmvorrichtung nach einem der Ansprüche 1 bis 8, **dadurch gekennzeichnet, dass** der Sensor für eine Alarmvorrichtung ein gedrucktes Muster oder eine Strukturschicht (26) enthält, die auf die erste Außenseite (8) und/oder die zweite Außenseite (13) gedruckt bzw. geklebt ist.

10. Sensor für eine Alarmvorrichtung nach einem der Ansprüche 1 bis 9, **dadurch gekennzeichnet, dass** der Sensor für eine Alarmvorrichtung mindestens ein Solarpaneel (27) enthält, das auf der ersten Außenseite (8) und/oder der zweiten Außenseite (13) angeordnet und elektrisch mit der ersten Leiterplatte des Sockels (1) verbunden ist.

11. Sensor für eine Alarmvorrichtung nach einem der Ansprüche 1 bis 10, **dadurch gekennzeichnet, dass** die Dicke der gesamten Schmalseite (19) des Zusammenbaus der ersten und zweiten Wände (7, 12) zwischen 2,7 Millimeter und 5 Millimeter liegt.

12. Sensor für eine Alarmvorrichtung nach einem der Ansprüche 1 bis 11, **dadurch gekennzeichnet, dass** die Dicke der ersten Wand (7) im Bereich des ersten Hohlraums (10, 10') und/oder der zweiten Wand (12) im Bereich des zweiten Hohlraums (15, 15') zwischen 0,4 Millimeter und 0,8 Millimeter liegt, vorzugsweise gleich 0,5 Millimeter ist.

13. Sensor für eine Alarmvorrichtung nach einem der Ansprüche 1 bis 12, **dadurch gekennzeichnet, dass** das die erste Wand (7) bildende Isoliermaterial ausgewählt wird unter einem Epoxid-Polymer, einem hochdichten Epoxid-Polymer, einem Verbund aus einem Epoxid-Polymer und Glasfaser, vorzugsweise FR-4.

14. Sensor für eine Alarmvorrichtung nach einem der Ansprüche 1 bis 13, **dadurch gekennzeichnet, dass** das die zweite Wand (12) bildende Isoliermaterial ausgewählt wird unter einem Epoxid-Polymer, einem hochdichten Epoxid-Polymer, einem Verbund aus einem Epoxid-Polymer und Glasfaser, vorzugsweise FR-4, einem Styrol-Polymer, vorzugsweise Acrylnitril-Butadien-Styrol, einem Polycarbonat-Polymer, einem Polymer mit Flüssigkristallen.

15. Sensor für eine Alarmvorrichtung nach einem der Ansprüche 2 bis 14, **dadurch gekennzeichnet, dass** das Material der Schweißnaht (17) eine Metalllegierung enthält, die Zinn, Kupfer und Silber enthält.

16. Sensor für eine Alarmvorrichtung nach einem der Ansprüche 5 bis 15, **dadurch gekennzeichnet, dass** das den Rahmen (20) bildende Material unter einem Kunststoff oder einem Elastomermaterial ausgewählt wird.

17. Sensor für eine Alarmvorrichtung nach einem der Ansprüche 1 bis 16, **dadurch gekennzeichnet, dass** die erste Leiterplatte eine dreidimensionale Leiterplatte ist, die eine Vielzahl von Hohlräumen (29') enthält, in die mindestens eines der elektronischen Bauteile (3, 30) integriert ist.

18. Sensor für eine Alarmvorrichtung nach einem der Ansprüche 1 bis 3 und 5 bis 17, **dadurch gekennzeichnet, dass** die zweite Leiterplatte eine dreidimensionale Leiterplatte ist, die eine Vielzahl von Hohlräumen (29) enthält, die zumindest zum Teil mindestens eines der elektronischen Bauteile (3) aufnehmen.

19. Sensor für eine Alarmvorrichtung nach einem der Ansprüche 1, 2, 4 bis 17, **dadurch gekennzeichnet, dass** das Werkstück aus Polymermaterial eine Vielzahl von Hohlräumen (29) enthält, die zumindest zum Teil mindestens eines der elektronischen Bauteile (3) aufnehmen.

20. Sensor für eine Alarmvorrichtung nach einem der Ansprüche 17 bis 19, **dadurch gekennzeichnet, dass** mindestens einer der Hohlräume (29, 29') zum Teil oder vollständig von einer leitenden Schicht (35) bedeckt ist.

21. Sensor für eine Alarmvorrichtung nach einem der Ansprüche 1 bis 20, **dadurch gekennzeichnet, dass** eines der elektronische Bauteile der ersten Leiterplatte aus einem Abrisserfassungsorgan (30) besteht, das ein Betätigungselement (31) enthält, das fähig und dazu bestimmt ist, gegen einen Träger (S) in Anlage zu kommen, wenn der Sensor für eine Alarmvorrichtung an einem Träger (S) befestigt wird, und dass die erste Wand (7) der ersten Leiterplatte die Durchgangsaufnahme (32) enthält, die zumindest zum Teil das Abrisserfassungsorgan (30) aufnimmt, und dessen Betätigungselement (31) von der ersten Außenseite (8) vorsteht und an der ersten Zusammenbauseite (9) durch Befestigungseinrichtungen (33) befestigt ist.

22. Sensor für eine Alarmvorrichtung nach Anspruch 21, **dadurch gekennzeichnet, dass** das Abrisserfassungsorgan (30) ein normalerweise offener monostabiler Schalter ist.

23. Sensor für eine Alarmvorrichtung nach einem der Ansprüche 1 bis 22, **dadurch gekennzeichnet, dass** die elektronischen Bauteile (3) einen akustischen Anzeiger und/oder einen optischen Anzeiger und/oder Sende- und Empfangseinrichtungen elektromagnetischer Wellen und/oder einen Mikrocontroller enthalten.

24. Verfahren zur Herstellung eines Sensors für eine Alarmvorrichtung, **dadurch gekennzeichnet, dass** der Sensor für eine Alarmvorrichtung nach einem der Ansprüche 1 bis 23 ist, und dass das Herstellungsverfahren mindestens enthält:
- einen Zusammenbauschritt, während dessen die erste Wand (7) und die zweite Wand (12) übereinander angeordnet und durch Zusammenbau der ersten Zusammenbauseite (9) und der zweiten Zusammenbauseite (14) zusammengebaut werden,
- einen Schweißschritt, während dessen die erste Zusammenbauseite (9) und die zweite Zusammenbauseite (14) miteinander verschweißt werden.

25. Verfahren nach Anspruch 24, **dadurch gekennzeichnet, dass** der Schweißschritt durch manuelles oder robotisiertes Schweißen mit Lötkolben oder durch Schwalllöten oder durch selektives Löten oder durch Laserschweißen durchgeführt wird.

26. Verfahren nach Anspruch 24, **dadurch gekennzeichnet, dass** während eines Siebdruckschritts vor dem Zusammenbauschritt und dem Schweißschritt Lötpaste durch eine Schablone auf die erste Zusammenbauseite (9) und/oder die zweite Zusammenbauseite (14) aufgebracht wird, und dass der Schweißschritt durch Umschmelzen in einem Ofen durchgeführt wird.

## Claims

1. Sensor for an alarm device, comprising at least:
- a baseplate (1),
- a cover (2),
- a set of electronic components (3, 30) that can and are intended to be powered by an electrical power supply (4), the baseplate (1) and the cover (2) forming at least one housing (10, 10', 15, 15', 29, 29', 32) comprising the electronic components (3, 30) and/or said electrical power supply (4),
the electronic components (3) comprise an accelerometer and/or a magnetometer and/or a magneto resistive component,
sensor for an alarm device **characterized in that**:
the baseplate (1) is composed of a first printed circuit in which said set of electronic components (3, 30) is incorporated,
the first printed circuit comprises a first wall (7) made of insulating material comprising a first outer face (8) and a first assembling face (9) opposite the first outer face (8), the first assembling face (9) comprising at least one first cavity (10, 10') that can and is intended to at least partly receive said electrical power supply (4) and that is open on a first rim (11) of the first wall (7),
the electronic components (3, 30) are incorporated at least partly in the first wall (7), the cover (2) comprises a second wall (12) comprising a second outer face (13) and a second assembling face (14) opposite the second outer face (13), the second assembling face (14) comprising at least one second cavity (15, 15') that can and is intended to at least partly receive said electrical power supply (4) and that is open on a second rim (16) of the second wall (12),
the first wall (7) and the second wall (12) are superposed and assembled with one another by the assembly of the first assembling face (9) and the second assembling face (14) by the assembling means (17, 17'),
the first cavity (10, 10') and the second cavity (15, 15') are disposed facing one another to form at least one housing for receiving the electrical power supply (4) comprising an access orifice (18) provided with an overall rim (19) of the assembly of the first and second walls (7, 12).

2. Sensor for an alarm device according to Claim 1, **characterized in that** the assembling means comprise at least one solder joint (17).

3. Sensor for an alarm device according to either one of Claims 1 and 2, **characterized in that** the cover (2) is composed of a second printed circuit comprising the second wall (12) and of which at least a part of the second assembling face (14) comprises at least one conductive layer.

4. Sensor for an alarm device according to either one of Claims 1 and 2, **characterized in that** the cover (2) is composed of a piece made of moulded or injected polymer material forming the second wall (12) and of which at least a part of the second assembling face (14) comprises at least one conductive layer (35).

5. Sensor for an alarm device according to any one of Claims 1 to 4, **characterized in that** the sensor for an alarm device comprises a frame (20) surrounding the overall rim (19) of the assembly of the first and second walls (7, 12), said frame (20) being fixed to the first wall (7) and/or to the second wall (12) by removable fixing means (21, 21').

6. Sensor for an alarm device according to Claim 5, **characterized in that** the frame (20) has a removable portion (22) disposed facing the access orifice (18) to block the access orifice (18) in a closed position (P1) and to be removed from the access orifice (18) to give access to the access orifice (18) in an open position (P2) .

7. Sensor for an alarm device according to any one of Claims 1 to 6, **characterized in that** the first cavity (10, 10') comprises at least one first electrical contact (23, 23') and one second electrical contact (24, 24') that can and are intended to be linked electrically to the electrical power supply (4).

8. Sensor for an alarm device according to any one of Claims 1 to 7, **characterized in that** the first and second cavities (10, 10', 15, 15') comprise an electrical power supply (4) chosen on its own or in combination from among: a button-type electrical cell, a battery, a rechargeable or non-rechargeable battery, a rechargeable or non-rechargeable lithium-ion battery or a capacitor.

9. Sensor for an alarm device according to any one of Claims 1 to 8, **characterized in that** the sensor for an alarm device comprises a printed pattern or an appearance layer (26) respectively printed or glued onto the first outer face (8) and/or the second outer face (13).

10. Sensor for an alarm device according to any one of Claims 1 to 9, **characterized in that** the sensor for an alarm device comprises at least one solar panel (27) disposed on the first outer face (18) and/or the second outer face (13) and linked electrically to the first printed circuit of the baseplate (1).

11. Sensor for an alarm device according to any one of Claims 1 to 10, **characterized in that** the thickness of the overall rim (19) of the assembly of the first and second walls (7, 12) is between 2.7 millimetres and 5 millimetres.

12. Sensor for an alarm device according to any one of Claims 1 to 11, **characterized in that** the thickness of the first wall (7) at the first cavity (10, 10') and/or of the second wall (12) at the second cavity (15, 15') is between 0.4 millimetre and 0.8 millimetre, preferentially equal to 0.5 millimetre.

13. Sensor for an alarm device according to any one of Claims 1 to 12, **characterized in that** the insulating material forming the first wall (7) is chosen from among an epoxy polymer, a high-density epoxy polymer, an epoxy polymer and glass fibre composite, preferentially FR-4.

14. Sensor for an alarm device according to any of Claims 1 to 13, **characterized in that** the insulating material forming the second wall (12) is chosen from among an epoxy polymer, a high-density epoxy polymer, an epoxy polymer and glass fibre composite, preferentially FR-4, a styrenic polymer preferentially, acrylonitrile butadiene styrene, a polycarbonate polymer, a liquid crystal polymer.

15. Sensor for an alarm device according to any one of Claims 2 to 14, **characterized in that** the material of the solder joint (17) comprises a metal alloy comprising tin, copper and silver.

16. Sensor for an alarm device according to any one of Claims 5 to 15, **characterized in that** the material forming the frame (20) is chosen from among a plastic material or an elastomer material.

17. Sensor for an alarm device according to any one of Claims 1 to 16, **characterized in that** the first printed circuit is a three-dimensional printed circuit comprising a plurality of cavities (29') in which are incorporated at least one of the electronic components (3, 30).

18. Sensor for an alarm device according to any one of Claims 1 to 3 and 5 to 17, **characterized in that** the second printed circuit is a three-dimensional printed circuit comprising a plurality of cavities (29) at least partly receiving at least one of the electronic components (3).

19. Sensor for an alarm device according to any one of Claims 1, 2, 4 to 17, **characterized in that** the piece made of polymer material comprises a plurality of cavities (29) at least partly receiving at least one of the electronic components (3).

20. Sensor for an alarm device according to any one of Claims 17 to 19, **characterized in that** at least one of the cavities (29, 29') is partly or totally covered by a conductive layer (35).

21. Sensor for an alarm device according to any one of Claims 1 to 20, **characterized in that** one of the electronic components of the first printed circuit consists of a tear-out detection member (30) comprising an actuation element (31) that can and is intended to come to bear against a support (S) when the sensor for an alarm device is fixed to a support (S) and **in that** the first wall (7) of the first printed circuit comprises a through-housing (32) at least partly receiving the tear-out detection member (30) and of which the actuation element (31) protrudes from the first outer face (8) and is fixed to the first assembling face (9) by fixing means (33) .

22. Sensor for an alarm device according to Claim 21, **characterized in that** the tear-out detection member (30) is a normally-open monostable switch.

23. Sensor for an alarm device according to any one of Claims 1 to 22, **characterized in that** the electronic components (3) comprise a sound indicator and/or a visual indicator and/or electromagnetic wave emission and reception means and/or a microcontroller.

24. Method for manufacturing a sensor for an alarm device, **characterized in that** the sensor for an alarm device is according to any one of Claims 1 to 23, and **in that** the manufacturing method comprises at least:
- an assembling step, during which, the first wall (7) and the second wall (12) are superposed and assembled with one another by assembling the first assembling face (9) and the second assembling face (14),
- a soldering step, during which the first assembling face (9) and the second assembling face (14) are soldered to one another.

25. Method according to Claim 24, **characterized in that** the soldering step is performed by manual or robotized soldering with a soldering iron or by wave soldering or by selective brazing or by laser bonding.

26. Method according to Claim 24, **characterized in that** during a screen-printing step prior to the assembly step and to the soldering step, soldering paste is deposited through a stencil on the first assembling face (9) and/or the second assembling face (14) and **in that** the soldering step is performed by refusion in a furnace.
